# EUROPÄISCHE PATENTSCHRIFT

(11) **EP 1 957 942 B1**
(45) Veröffentlichungstag und Bekanntmachung des Hinweises auf die Patenterteilung: **11.01.2012**
(21) Anmeldenummer: 06830050.8
(22) Anmeldetag: 21.11.2006
(51) Int. Cl.: G01D 5/00

(54) **AUSWERTESCHALTUNG ZUR VERARBEITUNG VON DIGITALEN SIGNALEN, VERFAHREN UND SENSORANORDNUNG**
EVALUATION CIRCUIT FOR PROCESSING DIGITAL SIGNALS, METHOD AND SENSOR ASSEMBLY
CIRCUIT D'EVALUATION UTILISE POUR TRAITER DES SIGNAUX NUMERIQUES, PROCEDE ET DISPOSITIF DE DETECTION

(30) Priorität: 24.11.2005 DE 102005055951
(43) Veröffentlichungstag der Anmeldung: 20.08.2008
(73) Patentinhaber: ROBERT BOSCH GMBH, 70442 Stuttgart (DE)
(72) Erfinder: WREDE, Martin, 72770 Reutlingen (DE); FREY, Volker, 72072 Tuebingen (DE)
(86) Internationale Anmeldenummer: PCT/EP2006/068701
(87) Internationale Veröffentlichungsnummer: WO 2007/060154

(56) Entgegenhaltungen:
- WO-A-93/16354
- DE-A1- 10 121 716
- DE-A1- 10 217 575

## Beschreibung

### Stand der Technik

Die Erfindung geht aus von einer Auswerteschaltung nach der Gattung des Hauptanspruchs. Eine solche ist beispielsweise aus der Druckschrift DE 199 55 513 A1 und DE 102 17 575 bekannt. Derartige Auswerteschaltungen, die auch als Auswerte-IC oder ASIC bezeichnet werden, zur Verarbeitung von Sensorsignalen, sind auf den jeweiligen Anwendungsfall angepasst. Beispielsweise weisen sie einen bestimmten Messbereich und eine bestimmte Auflösung auf, die den Parametern des durch den Sensor aufgenommenen Eingangssignals, insbesondere dessen Maximalpegel angepasst sind. Bei unterschiedlichen Eingangssignalen, die sich bei verschiedenen Anwendungen ergeben, werden daher in der Regel unterschiedliche Sensoren und Auswerteschaltungen benötigt, um die jeweils geforderten Messbereiche und Auflösungen zur Verfügung zu stellen. Des Weiteren können bei bestimmten Anwendungen Eingangssignalspitzen auf, die bei einem festen Messbereich nicht ohne entsprechende Einbußen in der Auflösung dargestellt werden können. Weiterhin ist nachteilig, dass der Dynamikbereich des Sensors vergleichsweise begrenzt ist.

### Vorteile der Erfindung

Die erfindungsgemäße Auswerteschaltung mit den Merkmalen des Hauptanspruchs hat demgegenüber den Vorteil, dass verschiedenartige Sensoren mit nur einer Art von Auswerteschaltung ohne die beschriebenen Nachteile für verschiedene Anwendungen, insbesondere mit unterschiedlichen Messbereichen, Empfindlichkeiten und Auflösungen, einsetzbar sind. Die erfindungsgemäße Auswerteschaltung verfügt dazu über eine Mehrzahl von Signalpfaden, denen je ein Satz von Parametern zugeordnet ist, wobei die Parameter beispielsweise die Verstärkung, den Messbereich und/oder die Auflösung des jeweiligen Signalpfads definieren. Dadurch weist die erfindungsgemäße Auswerteschaltung einen wesentlich größeren Dynamikbereich auf. Vorteilhafterweise ist so der prinzipiell zugängliche Dynamikbereich von Sensoren besser nutzbar. Darüber hinaus ist die erfindungsgemäße Auswerteschaltung flexibler einsetzbar und die Typenvielfalt reduziert sich. Ein Eingangsdatenwort wird erfindungsgemäß durch mindestens einen Signalpfad zu einem verarbeiteten Datenwort verarbeitet. Das Eingangsdatenwort kann auch durch mehrere und insbesondere durch alle Signalpfade verarbeitet werden. Unter Datenwort ist allgemein eine digitale Datenmenge zu verstehen, unter Eingangsdatenwort die aus einem analogen Signal durch Digitalisierung mittels eines dem Fachmann bekannten Analog-DigitalWandlers (Sigma-Delta-Wandler) erhaltene Datenmenge.

Die Anzahl der Signalpfade, sowie die Festlegung der Sätze von Parametern können dem jeweiligen Einsatzgebiet bzw. der Anwendung angepasst werden. Die Anzahl der Signalpfade ist theoretisch beliebig groß. In der praktischen Anwendung wird die Anzahl durch einen notwendigen Messbereich mit entsprechender Auflösung je Signalpfad begrenzt. Bei bekannten Anwendungen, beispielsweise für Inertialsensoren, Mediensensoren oder Drucksensoren liegt die Anzahl der sinnvoll einsetzbaren Signalpfade typischerweise bei zwei bis vier. Die Sätze von Parametern werden üblicherweise bereits bei der Produktion der erfindungsgemäßen Auswerteschaltung den jeweiligen Signalpfaden zugeordnet. Es ist jedoch ebenfalls denkbar, die erfindungsgemäße Auswerteschaltung zunächst ohne eine Zuordnung von Parametersätzen herzustellen und die Parametersätze erst später, entsprechend der jeweiligen Anwendung, in einem einmaligen Prozess der Initialisierung festzulegen. Der Fachmann versteht, dass dabei auch einzelne, nicht benötigte Signalpfade abgeschaltet werden können. Die erfindungsgemäße Auswerteschaltung ist so besonders kostengünstig herstellbar und die Teilevielfalt reduziert sich.

Durch die in den Unteransprüchen aufgeführte Maßnahmen sind vorteilhafte Weiterbildungen und Verbesserungen der in den nebengeordneten Ansprüchen angegebenen Auswerteschaltung, des Verfahrens und der Sensoranordnung möglich.

Die Auswerteschaltung weist in einer bevorzugten Ausführungsform einen Schwellwertschalter auf, der in Abhängigkeit des Eingangsdatenworts einen der Signalpfade auswählt oder in Abhängigkeit des Eingangsdatenworts eines der verarbeiteten Datenworte der Signalpfade als Ausgangsdatenwort herausfiltert. Die Eingangsdatenworte können also beispielsweise beim Überschreiten von festgelegten Schwellwerten bereits vor Durchlaufen der Signalpfade einem von diesen zugeordnet werden. Alternativ kann der Schwellwertschalter hinter den Signalpfaden angeordnet sein und dort die bereits von allen Signalpfaden parallel verarbeiteten Datenworte auf entsprechende Weise filtern. Das digitale Signal wird bei dieser integrierten Bewertung bzw. Selektion ohne Einfluss von außen durch den entsprechenden Signalpfad verarbeitet. Die Ausführungsform ist daher besonders einfach und unkompliziert einsetzbar. Ein Ausgangssignal aus den unterschiedlich verarbeiteten Ausgangsdatenwörtern kann später rekonstruiert werden. Dazu werden den verarbeiteten Datenworten Kodierungen, beispielsweise Informationen über den Signalpfad hinzugefügt.

In einer weiteren, bevorzugten Ausführungsform weist die Auswerteschaltung eine Schnittstelle auf, über die von außen mindestens einer der Signalpfade zur Verarbeitung des Eingangsdatenworts auswählbar ist oder mindestens eines der verarbeiteten Datenworte zur Ausgabe als Ausgangsdatenwort auswählbar ist. Die Auswahl des gewünschten Signalpfads kann durch einen Mikrokontroller eines Steuergeräts erfolgen, beispielsweise über ein sogenanntes serial peripheral interface, SPI. Der jeweilige Signalpfad wird adressiert bzw. ist über einen bestimmten SPI-Befehl ansteuerbar. Bei dieser Ausführungsform hat der Anwender vorteilhafterweise Einfluss auf die Auswahl der Signalpfade. Bei der Auswahl nur eines Signalpfads ist eine Kodierung der verarbeiteten Datenworte in diesem Fall nicht notwendig, da der jeweils ausgewählte Signalpfad bekannt ist. Der Fachmann versteht, dass auch mehrere, verarbeitete und kodierte Datenwörter, die aus der Verarbeitung eines Eingangsdatenworts durch mehrere Signalpfade entstanden sind, als Datenwort ausgegeben werden können. Besonders einfach ist daher eine Ausführungsform der Erfindung, in der keine Selektion der verarbeiteten Datenworte stattfindet, sondern alle verarbeiteten Datenworte mit hinzugefügten Informationen über den Signalpfad kodiert werden und gemeinsam das Ausgangsdatenwort bilden. Eine Auswahl ist beispielsweise mit einem Mikrokontroller nachträglich jederzeit möglich.

Das erfindungsgemäße Verfahren mit den Merkmalen des nebengeordneten, unabhängigen Verfahrensanspruchs hat den Vorteil, dass Sensordaten mit nur einer Auswerteschaltung für verschiedene Anwendungen mit unterschiedlichen Messbereichen, Empfindlichkeiten und Auflösungen eingesetzt werden können, bzw. dass der Dynamikbereich von Sensoren besser ausgenutzt wird.

Dem Eingangsdatenwort wird bevorzugt einer der Signalpfade durch einen Schwellwertschalter zugeordnet. Alternativ wird das Ausgangsdatenwort durch den Schwellwertschalter aus den verarbeiteten Datenworten herausgefiltert. Diese integrierte Selektion der Signalpfade erfordert keine Steuerung von außen.

In einer weiteren Ausführungsform des erfindungsgemäßen Verfahrens wird von außen mindestens einer der Signalpfade zur Verarbeitung des Eingangsdatenworts ausgewählt wird oder mindestens eines der verarbeiteten Datenworte zur Ausgabe als Ausgangsdatenwort ausgewählt. Die Auswahl erfolgt über eine Schnittstelle der Auswerteschaltung, beispielsweise zu einem Mikrokontroller eines Steuergeräts. Besonders bevorzugt wird dem verarbeiteten Datenworten bei der Verarbeitung eine Information über den jeweiligen Signalpfad hinzugefügt, durch den die Verarbeitung erfolgt. Insbesondere werden die Informationen über den entsprechenden Satz von Parametern, also beispielsweise die Verstärkung und/oder der Messbereich, hinzugefügt. Bei digitalen Daten ist das Hinzufügen und Verknüpfen zusätzlicher Informationen besonders leicht möglich. Das Ausgangsdatenwort wird ebenfalls besonders bevorzugt aus einer beliebigen Anzahl von verarbeiteten Datenworten mit den hinzugefügten Informationen gebildet. Durch die hinzugefügten Informationen besteht jederzeit die Möglichkeit die Daten zu rekonstruieren. Insbesondere kann das Ausgangsdatenwort aus allen verarbeiteten Datenworten mit den hinzugefügten Informationen gebildet werden, ein solches Verfahren erfordert zunächst keine Auswahl und ist daher besonders einfach durchzuführen.

Beispielsweise zu einem späteren Zeitpunkt wird dann besonders bevorzugt aus dem Ausgangsdatenwort eines der verarbeiteten Datenworte zur weiteren Verarbeitung ausgewählt. Dies geschieht insbesondere anhand der hinzugefügten Informationen, um beispielsweise jeweils das verarbeitete Datenwort mit der optimalen Auflösung auszuwählen.

Ein weiterer Gegenstand der Erfindung ist eine Sensoranordnung mit mindestens einem Sensor, mit einer erfindungsgemäßen Auswerteschaltung und gegebenenfalls einem Wandler zur Umwandlung analoger Sensorsignale in digitale Sensorsignale, wobei die digitalen Sensorsignale nach dem erfindungsgemäßen Verfahren durch die Auswerteschaltung auswertbar sind. Dadurch ist es vorteilhaft möglich, einen multifunktionalen Sensor für verschiedene Messbereiche in einem Bauelement zu schaffen, wobei keine Verluste in der Auflösung oder im Messbereich auftreten.

### Ausführungsbeispiel

Ausführungsbeispiele der Erfindung sind in der Zeichnung dargestellt und in der nachfolgenden Beschreibung näher erläutert.

Es zeigen
**Figur 1** eine schematische Darstellung einer ersten Ausführungsform der Erfindung,
**Figur 2** eine alternative Ausführungsform und
**Figuren 3a und 3b** ein Anwendungsbeispiel der Ausführungsform nach **Figur 1****.**

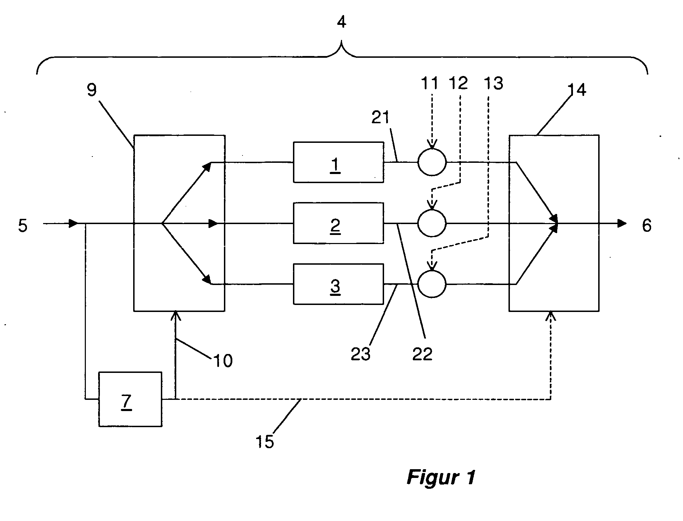

In der **Figur 1** ist ein Verarbeitungsschema einer erfindungsgemäßen Auswerteschaltung 4 bzw. eines erfindungsgemäßen Verfahrens dargestellt. Ein digitales Eingangssignal 5 ist eine Abfolge von Eingangsdatenworten 5, die beispielsweise digitalisierte Messwerte eines Sensors sind, der hier nicht dargestellt ist. Das Eingangssignal 5 liegt sowohl an einem Selektor 9 an, als auch an einem Schwellwertschalter 7. Der Schwellwertschalter 7 vergleicht den durch das Eingangsdatenworts 5 dargestellten Messwert mit vorgegeben Messwertbereichen, die jeweils einem Signalpfad 1, 2, 3 entsprechen, und ermittelt so für jedes Eingangsdatenwort 5 den vorgesehenen Signalpfad 1, 2, 3. Jedem Signalpfad ist jeweils ein unterschiedlicher Satz von Parametern zugeordnet, der die Art der Verarbeitung von Signalen bestimmt. Im dargestellten Beispiel weist die Auswerteschaltung 4 drei Signalpfade 1, 2, 3 auf. Entsprechend sind drei Messwertbereiche vorgesehen, so dass der Schwellwertschalter 7 in Abhängigkeit jeweils der Eingangsdatenworte 5 entscheidet, welchem Messbereich, und damit welchem Signalpfad 1, 2, 3, das aktuelle Datenwort 5 zuzuordnen ist. Es wäre jedoch auch jede andere Anzahl von Messwertbereichen und zugehörigen Signalpfaden denkbar. Der Schwellwertschalter 7 steuert den Selektor 9 über eine Verbindung, die durch eine mit 10 bezeichnete Linie dargestellt ist. In dem Selektor 9 wird das Eingangsdatenwort 5 einer der Signalpfade 1, 2, 3 zur Verarbeitung zugeordnet. Die von den Signalpfaden 1, 2, 3 in Abhängigkeit von den Eingangsdatenworten 5 verarbeiteten Datenworte 21, 22, 23 werden in einem Deselektor 14 wieder zu einem Signal 6 zusammengeführt. Um später ein Ausgangsdatenwort 6 bewerten zu können, ist eine jedem verarbeiteten Datenwort 21, 22, 23 jeweils zugeordnete Information 11,12,13 notwendig, die angibt, welchen der Signalpfade 1, 2, 3 das Ausgangsdatenwort 6 durchlaufen hat. Diese Information 11, 12, 13 wird als digitale Kodierung dem jeweiligen verarbeiteten Datenwort 21, 22, 23 hinzugefügt. Diese sogenannte Headerinformation kann den Satz von Parametern beinhalten, beispielsweise den Messbereich oder die Verstärkung des jeweiligen Signalpfads 1, 2, 3. Er kann auch einen Rückbezug enthalten, aus dem die Parameter hervorgehen. Der Fachmann erkennt, dass der Schwellwertschalter anstelle des Selektors 9 oder zusätzlich auch den Deselektor 14 steuern kann, was durch die gestrichelte, mit 15 bezeichnete Linie angedeutet ist. In diesem Fall würde das Eingangsdatenwort 5 im Selektor 9 über alle Signalpfade 1, 2 und 3 gleichzeitig geleitet, so dass anschließend drei verarbeitete Datenwörter 21, 22, 23 mit Headerinformation 11, 12, 13 am Deselektor 14 anliegen. Der Schwellwertschalter selektiert auf Grund des Pegels des Eingangsdatenworts 5 eines der verarbeiteten Datenworte 21, 22, 23 mit Headerinformation 11, 12 ,13 als Ausgangsdatenwort 6.

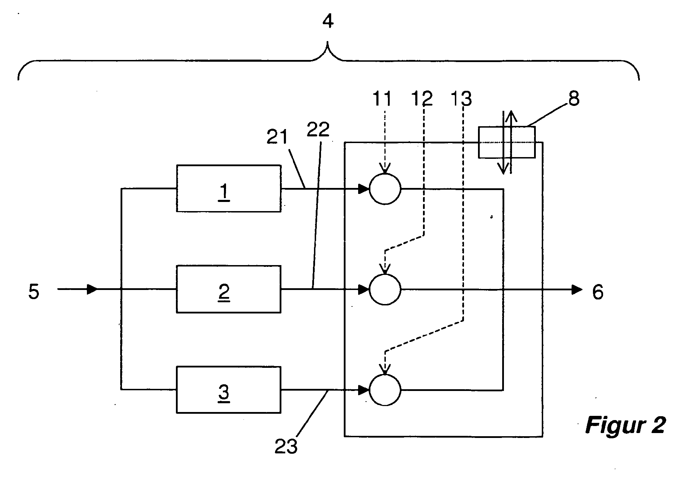

in **Figur 2** ist eine alternative Ausführungsform der erfindungsgemäßen Auswerteschaltung 4, sowie des erfindungsgemäßen Verfahrens in der selben, schematischen Weise dargestellt. Das Eingangsdatenwort 5 wird parallel über jeden Signalpfad 1, 2 und 3 verarbeitet, was zu drei verarbeiteten Datenwörtern 21, 22, 23 mit jeweils hinzugefügter Headerinformation 11, 12, 13 führt, die als Datenwort 6 zur Verfügung stehen.

In einer weiteren Ausführungsform weist die Auswerteschaltung 4 eine Schnittstelle 8 auf, die eine Auswahl eines der verarbeiteten Datenworte 21, 22, 23 ermöglicht, das dann als Ausgangsdatenwort 6 ausgegeben wird. Der Fachmann erkennt, dass in diesem Fall keine Headerinformationen 11, 12, 13 notwendig sind, da dem Anwender, der die Auswahl von außen vornimmt, der ausgewählte Signalpfad 1, 2, 3 bekannt ist. Die Auswahl kann beispielsweise von einem Mikrokontroller eines Steuergeräts vorgenommen werden, das hier nicht dargestellt ist.

Die Auswahl durch den Anwender kann ebenso vor den Signalpfaden 1, 2, 3 erfolgen. Der Schwellwertschalter 7 in **Figur 1** könnte beispielsweise durch die Schnittstelle 8 ersetzt werden. In dem Fall würde dann nur einer der Signalpfade 1, 2, 3 durchlaufen. Eine Kodierung des Ausgangsdatenworts 6 wäre nicht notwendig. Werden den verarbeiteten Datenworten 21, 22, 23 hingegen die Informationen 11, 12, 13 über den jeweils durchlaufenen Signalpfad 1, 2, 3 hinzugefügt, dann können auch alle verarbeiteten Datenworte 21, 22, 23 mit der dazugehörigen Headerinformation 11, 12, 13 gemeinsam das Ausgangsdatenwort 6 bilden. Eine Auswahl findet in diesem Fall zunächst nicht statt. Das Ausgangssignal aus Ausgangsdatenworten 6 kann zu einem beliebigen, späteren Zeitpunkt, beispielsweise mit einem Mikrokontroller, anhand der Headerinformationen 11, 12, 13 weiterverarbeitet, beispielsweise dargestellt werden.

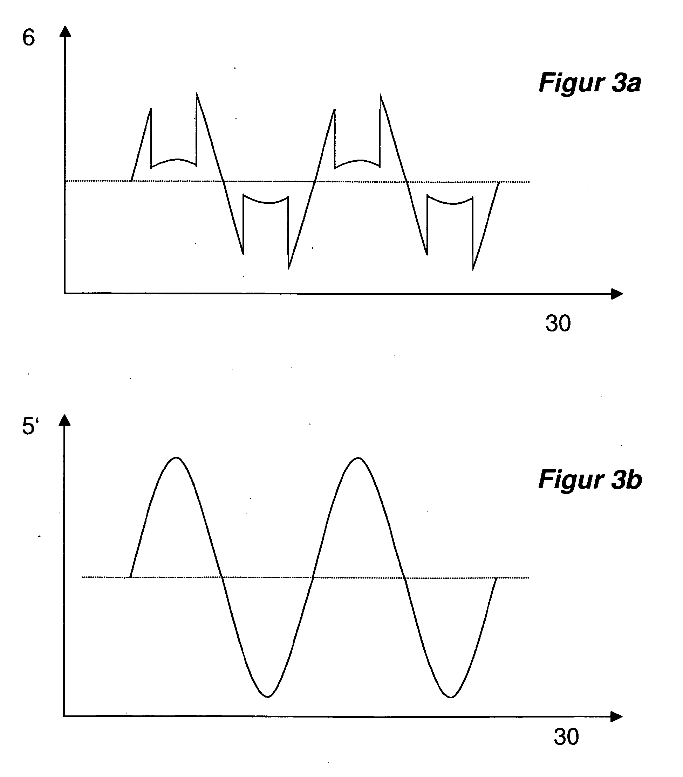

Ein Beispiel für die Abbildung bzw. Rekonstruktion von Messwerten mit Hilfe der Headerinformationen 11, 12, 13 ist in den **Figuren 3a und 3b** dargestellt. Das Eingangssignal 6 ist ein sinusförmiges Signal, das digitalisiert, also in Datenworten 6 durch die erfindungsgemäße Auswerteschaltung 4 in der Ausführung gemäß **Figur 1** verarbeitet wird. Der Schwellwertschalter 7 ordnet das Eingangsdatenwort 5 einem der Signalpfade 1, 2, 3 zu. Das Ausgangssignal aus Ausgangsdatenworten 6 ist in dem Diagramm in Figur 3a über die Zeit 30 dargestellt. Das Signal ist unstetig, da bei Über- oder Unterschreiten vorgegebener Schwellwerte eine Umschaltung auf einen anderen Signalpfad mit einem anderen Satz von Parametern erfolgt. Es ist zu erkennen, dass jeweils bei Überschreiten eines bestimmten Absolutwerts eine Umschaltung erfolgt, wobei für den Bereich hoher absoluter Messwerte ein größerer Messbereich und eine geringere Verstärkung angewandt wird, wodurch das Ausgangssignal einerseits niedriger liegt und andererseits flacher verläuft. Da jedes Ausgangsdatenwort 6 den Messbereich und die Verstärkung als hinzugefügte Information enthält, lässt sich die Kurve 5' der ursprünglichen Eingangsdatenworte 5 rekonstruieren, wie in dem Diagramm in **Figur 3b** zu sehen ist, das eine Darstellung des ursprünglichen, sinusförmigen Eingangssignals zeigt. Es lässt sich so beispielsweise eine kombinierte Sensoranordnung realisieren, beispielsweise zur Messung von Beschleunigungen, die gleichfalls geringe Beschleunigungen mit hoher Auflösung und geringem Messbereich, wie hohe Beschleunigungen mit geringer Auflösung und großem Messbereich erfasst und verarbeitet.

## Patentansprüche

1. Auswerteschaltung (4) zur Verarbeitung von digitalen Signalen, wobei
- die Auswerteschaltung (4) ein Eingangsdatenwort (5) verarbeitet und ein Ausgangsdatenwort (6) ausgibt,
- die Auswerteschaltung (4) eine Mehrzahl von Signalpfaden (1, 2, 3) aufweist,
- die Verarbeitung des Eingangsdatenworts (5) durch mindestens einen der Signalpfade (1, 2, 3) erfolgt, und
- jedem Signalpfad (1, 2, 3) ein Satz von Parametern zugeordnet ist die unterschiedliche Verarbeitung des Eingangsdatenworts (5) zu einem verarbeiteten Datenwort (21, 22, 23) führt, das von den Parametern des jeweiligen Signalpfads (1, 2, 3) abhängig ist,
**dadurch gekennzeichnet dass**
die Auswerteschaltung (4) einen Schwellwertschalter (7) aufweist, der das Eingangsdatenwort (5) einem der Signalpfade (1, 2, 3) zuordnet oder das Ausgangsdatenwort (6) aus den verarbeiteten Datenworten (21, 22, 23) herausfiltert.

2. Auswerteschaltung (4) nach Anspruch 1, **dadurch gekennzeichnet, dass** die Auswerteschaltung (4) eine Schnittstelle (8) aufweist, wobei über die Schnittstelle (8) von außen mindestens einer der Signalpfade (1, 2, 3) zur Verarbeitung des Eingangsdatenworts (5) auswählbar ist oder mindestens eines der verarbeiteten Datenworte (21, 22, 23) zur Ausgabe als Ausgangsdatenwort (6) auswählbar ist.

3. Verfahren zur Verarbeitung von digitalen Signalen in einer Auswerteschaltung (4), wobei
- durch die Auswerteschaltung (4) ein Eingangsdatenwort (5) verarbeitet und ein Ausgangsdatenwort (6) ausgegeben wird,
- die Auswerteschaltung (4) eine Mehrzahl von Signalpfaden (1, 2, 3) aufweist,
- das Eingangsdatenwort (5) von mindestens einem der Signalpfade (1, 2, 3) verarbeitet wird,
- jedem Signalpfad (1, 2, 3) ein Satz von Parametern zugeordnet wird und
- die unterschiedliche Verarbeitung des Eingangsdatenworts (5) durch den jeweiligen Signalpfad (1, 2, 3) zu einem verarbeiteten Datenwort (21, 22, 23) in Abhängigkeit von den Parametern des jeweiligen Signalpfads (1, 2, 3) erfolgt,
**dadurch gekennzeichnet dass**
dem Eingangsdatenwort (5) einer der Signalpfade (1, 2, 3) durch einen Schwellwertschalter (7) zugeordnet wird, oder dass das Ausgangsdatenwort (6) durch den Schwellwertschalter (7) aus den verarbeiteten Datenworten (21, 22, 23) herausgefiltert wird.

4. Verfahren nach Anspruch 3, **dadurch gekennzeichnet, dass** von außen über eine Schnittstelle (8) der Auswerteschaltung (4) mindestens einer der Signalpfade (1, 2, 3) zur Verarbeitung des Eingangsdatenworts (5) ausgewählt wird oder mindestens eines der verarbeiteten Datenworte (21, 22, 23) zur Ausgabe als Ausgangsdatenwort (6) ausgewählt wird.

5. Verfahren nach einem der Ansprüche 3 oder 4, **dadurch gekennzeichnet, dass** den verarbeiteten Datenworten (21, 22, 23) bei der Verarbeitung eine Information (11, 12, 13) über den jeweiligen Signalpfad (1, 2, 3) hinzugefügt wird, durch den die Verarbeitung erfolgt.

6. Verfahren nach einem der Ansprüche 3 bis 5, **dadurch gekennzeichnet, dass** das Ausgangsdatenwort (6) aus einer beliebigen Anzahl von verarbeiteten Datenworten (21, 22, 23) mit den hinzugefügten Informationen (11, 12, 13) gebildet wird.

7. Verfahren nach einem der Ansprüche 3 bis 6, **dadurch gekennzeichnet, dass** aus dem Ausgangsdatenwort (6) eines der verarbeiteten Datenworte (21, 22, 23) zur weiteren Verarbeitung ausgewählt wird, vorzugsweise anhand der hinzugefügten Informationen (11, 12, 13).

8. Sensoranordnung mit mindestens einem Sensor, mit einer Auswerteschaltung (4) nach einem der Ansprüche 1 oder 2 und gegebenenfalls einem Wandler zur Umwandlung analoger Sensorsignale in digitale Sensorsignale, wobei die digitalen Sensorsignale nach einem Verfahren nach einem der Ansprüche 3 bis 7 durch die Auswerteschaltung (4) auswertbar sind.

## Claims

1. Evaluation circuit (4) for processing digital signals,
- the evaluation circuit (4) processing an input data word (5) and outputting an output data word (6),
- the evaluation circuit (4) having a plurality of signal paths (1, 2, 3),
- at least one of the signal paths (1, 2, 3) processing the input data word (5), and
- a set of parameters being assigned to each signal path (1, 2, 3) and the different processing of the input data word (5) leading to a processed data word (21, 22, 23) which is dependent on the parameters of the respective signal path (1, 2, 3),
**characterized in that**
the evaluation circuit (4) has a threshold value switch (7) which assigns the input data word (5) to one of the signal paths (1, 2, 3) or filters the output data word (6) from the processed data words (21, 22, 23).

2. Evaluation circuit (4) according to Claim 1, **characterized in that** the evaluation circuit (4) has an interface (8), the interface (8) being able to be used to select at least one of the signal paths (1, 2, 3) from the outside for the purpose of processing the input data word (5) or to select at least one of the processed data words (21, 22, 23) for output as an output data word (6).

3. Method for processing digital signals in an evaluation circuit (4),
- the evaluation circuit (4) processing an input data word (5) and outputting an output data word (6),
- the evaluation circuit (4) having a plurality of signal paths (1, 2, 3),
- at least one of the signal paths (1, 2, 3) processing the input data word (5),
- a set of parameters being assigned to each signal path (1, 2, 3), and
- the different processing of the input data word (5) by the respective signal path (1, 2, 3), in order to form a processed data word (21, 22, 23), being carried out on the basis of the parameters of the respective signal path (1, 2, 3),
**characterized in that**
a threshold value switch (7) assigns one of the signal paths (1, 2, 3) to the input data word (5), or **in that** the threshold value switch (7) filters the output data word (6) from the processed data words (21, 22, 23).

4. Method according to Claim 3, **characterized in that** an interface (8) of the evaluation circuit (4) is used to select at least one of the signal paths (1, 2, 3) from the outside for the purpose of processing the input data word (5) or to select at least one of the processed data words (21, 22, 23) for output as an output data word (6).

5. Method according to either of Claims 3 and 4, **characterized in that** an item of information (11, 12, 13) relating to the respective signal path (1, 2, 3) which carries out the processing is added to the processed data words (21, 22, 23) during processing.

6. Method according to one of Claims 3 to 5, **characterized in that** the output data word (6) is formed from any desired number of processed data words (21, 22, 23) with the added information (11, 12, 13).

7. Method according to one of Claims 3 to 6, **characterized in that** one of the processed data words (21, 22, 23) is selected from the output data word (6) for further processing, preferably using the added information (11, 12, 13).

8. Sensor arrangement having at least one sensor, having an evaluation circuit (4) according to either of Claims 1 and 2 and possibly having a converter for converting analogue sensor signals into digital sensor signals, the digital sensor signals being able to be evaluated by the evaluation circuit (4) in accordance with a method according to one of Claims 3 to 7.

## Revendications

1. Circuit d'analyse (4) pour le traitement de signaux numériques, dans lequel
- le circuit d'analyse (4) traite un mot de données d'entrée (5) et délivre un mot de données de sortie (6),
- le circuit d'analyse (4) présente une pluralité de chemins de signaux (1, 2, 3),
- le traitement du mot de données d'entrée (5) s'effectue par au moins l'un des chemins de signaux (1, 2, 3) et
- à chaque chemin de signaux (1, 2, 3) est associé un jeu de paramètres qui donne lieu à un traitement différent du mot de données d'entrée (5) pour produire un mot de données traité (21, 22, 23), lequel dépend des paramètres du chemin de signaux (1, 2, 3) correspondant,
**caractérisé en ce que**
le circuit d'analyse (4) présente un commutateur de valeur de seuil (7) qui associe le mot de données d'entrée (5) à l'un des chemins de signaux (1, 2, 3) ou qui extrait par filtrage le mot de données de sortie (6) des mots de données traités (21, 22, 23).

2. Circuit d'analyse (4) selon la revendication 1, **caractérisé en ce que** le circuit d'analyse (4) présente une interface (8), au moins l'un des chemins de signaux (1, 2, 3) pouvant être sélectionné depuis l'extérieur par le biais de l'interface (8) pour le traitement du mot de données d'entrée (5) ou au moins l'un des mots de données traités (21, 22, 23) pouvant être sélectionné pour être délivré en tant que mot de données de sortie (6).

3. Procédé de traitement de signaux numériques dans un circuit d'analyse (4), selon lequel
- un mot de données d'entrée (5) est traité et un mot de données de sortie (6) est délivré par le circuit d' analyse (4),
- le circuit d'analyse (4) présente une pluralité de chemins de signaux (1, 2, 3),
- le mot de données d'entrée (5) est traité par au moins l'un des chemins de signaux (1, 2, 3),
- à chaque chemin de signaux (1, 2, 3) est associé un jeu de paramètres et
- le traitement différent du mot de données d'entrée (5) par le chemin de signaux (1, 2, 3) pour produire un mot de données traité (21, 22, 23) s'effectue en fonction des paramètres du chemin de signaux (1, 2, 3) correspondant,
**caractérisé en ce que**
le mot de données d'entrée (5) est associé à l'un des chemins de signaux (1, 2, 3) par un commutateur de valeur de seuil (7) ou **en ce que** le mot de données de sortie (6) est extrait par filtrage des mots de données traités (21, 22, 23) par le commutateur de valeur de seuil (7).

4. Procédé selon la revendication 3, **caractérisé en ce qu'**au moins l'un des chemins de signaux (1, 2, 3) est sélectionné depuis l'extérieur par le biais d'une interface (8) du circuit d'analyse (4) pour le traitement du mot de données d'entrée (5) ou au moins l'un des mots de données traités (21, 22, 23) est sélectionné pour être délivré en tant que mot de données de sortie (6).

5. Procédé selon l'une des revendications 3 ou 4, **caractérisé en ce qu'**une information (11, 12, 13) sur le chemin de signaux (1, 2, 3) correspondant par le biais duquel a lieu le traitement est ajouté aux mots de données traités (21, 22, 23) lors du traitement.

6. Procédé selon l'une des revendications 3 à 5, **caractérisé en ce que** le mot de données de sortie (6) est formé d'un nombre quelconque de mots de données traités (21, 22, 23) auxquels ont été ajoutées les informations (11, 12, 13).

7. Procédé selon l'une des revendications 3 à 6, **caractérisé en ce que** l'un des mots de données traités (21, 22, 23) est sélectionné à partir du mot de données de sortie (6) en vue d'un traitement postérieur, de préférence au moyen des informations (11, 12, 13) ajoutées.

8. Arrangement de détection comprenant au moins un détecteur, comprenant un circuit d'analyse (4) selon l'une des revendications 1 ou 2 et le cas échéant un convertisseur pour convertir des signaux de détecteur analogiques en signaux de détecteur numériques, les signaux de détecteur numériques pouvant être analysés par le circuit d'analyse (4) conformément à un procédé selon l'une des revendications 3 à 7.
